# EUROPEAN PATENT SPECIFICATION

(11) **EP 1 999 290 B1**
(45) Date of publication and mention of the grant of the patent: **17.08.2011**
(21) Application number: 07753913.8
(22) Date of filing: 22.03.2007
(51) Int. Cl.: C23C 14/06, C23C 14/24, C23C 14/54

(54) **UNIFORMLY VAPORIZING METALS AND ORGANIC MATERIALS**
GLEICHMÄSSIGE BEDAMPFUNG VON METALLEN UND ORGANISCHEN MATERIALIEN
VAPORISATION UNIFORME DE MÉTAUX ET DE MATÉRIAUX ORGANIQUES

(30) Priority: 29.03.2006 US 392004
(43) Date of publication of application: 10.12.2008
(73) Proprietor: Global OLED Technology LLC, Wilmington, Delaware 19801 (US)
(72) Inventor: BOROSON, Michael Louis, Rochester, New York 14610 (US); LONG, Michael, Hilton, New York 14468 (US)
(74) Representative: Wibbelmann, Jobst
(86) International application number: PCT/US2007/007326
(87) International publication number: WO 2007/126719

(56) References cited:
- EP-A- 1 357 200
- US-A1- 2005 016 462
- US-A1- 2005 186 340

## Description

### FIELD OF THE INVENTION

The present invention relates to the field of physical vapor deposition, and more specifically to the co-deposition of metals and non-metallic materials from vapor.

### BACKGROUND OF THE INVENTION

An OLED device includes a substrate, an anode, a hole-transporting layer made of an organic compound, an organic luminescent layer with suitable dopants, an organic electron-transporting layer, and a cathode. OLED devices are attractive because of their low driving voltage, high luminance, wide-angle viewing and capability for full-color flat emission displays. Tang et al. described this multilayer OLED device in their U.S. Patents 4,769,292 and 4,885,211.

Physical vapor deposition in a vacuum environment is the principal way of depositing thin organic material films as used in small molecule OLED devices. Such methods are well known, for example Barr in U.S. 2,447,789 and Tanabe et al. in EP 0 982 411. The organic materials used in the making of OLED devices are often subject to degradation when maintained at or near the desired rate dependant vaporization temperature for extended periods of time. Exposure of sensitive organic materials to higher temperatures can cause changes in the structure of the molecules and associated changes in material properties.

In US Publication No. 2004/0135749, KONDAKOV et al. described an organic layer doped with a low work-function metal. For example, a layer of tris(8-quinolinolato)aluminum (III) (Alq) having 1.2% lithium by volume has useful properties. Such a layer was vacuum deposited onto a substrate at a coating station that included two heated boat sources, one each for Alq and lithium.

US2005/0186340 shows a method of vaporizing organic materials using two different heating regions and a metering of the vaporisation rate.

US2005/0016462 shows the co-vaporization of organic and metal-containing sources using a manifold and an evaporation crucible.

However, the use of separate sources can create a gradient effect in the deposited film where the material in the source closest to an advancing substrate is over represented in the initial film immediately adjacent the substrate because the material in the last source is over represented in the final film surface.

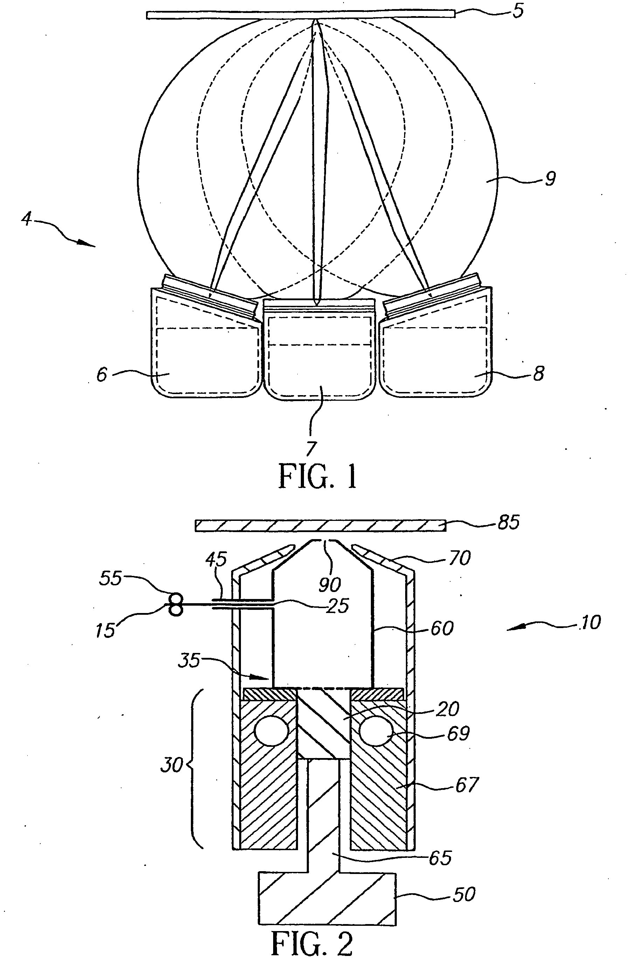

This gradient co-deposition is unavoidable in prior art sources where a single material is vaporized from each of multiple sources. FIG. 1 shows a cross-sectional view of such a prior-art vaporization device 4, which includes three individual sources 6, 7, and 8 for vaporizing organic material. Vapor plume 9 is desirably homogeneous in the materials from the different sources, but in reality varies in composition from side to side, resulting in a non-homogeneous coating on substrate 5.

A further limitation of previous sources is that the geometry of the vapor manifold changes as the material charges are consumed. This change requires that the heater temperature change to maintain a constant vaporization rate; however, it is observed that the plume shape of the vapor exiting the orifices changes as a function of the material thickness and distribution in the source.

### SUMMARY OF THE INVENTION

It is therefore an object of the present invention to allow a single source to uniformly deposit metals and non-metallic materials to form a layer on a substrate.

This object is achieved by a method for mixing and depositing first and second separate vaporized materials onto a substrate surface to form a layer wherein the first material includes a metal and the second material is non-metallic, comprising:
a) providing a mixing manifold disposed so that vaporized materials are deliverable onto the substrate surface;
b) providing first and second heating elements for separately vaporizing the first and second materials, the heating elements being disposed so that the vaporized materials are deliverable into the mixing manifold; and
c) metering at a controlled rate the first and second materials to the first and second heating elements respectively, so that vaporized materials, including the metal, are delivered to the mixing manifold where they are mixed and subsequently deposited onto the substrate surface to form the layer including the metal.

It is an advantage of the present invention that it permits materials having different vaporization rates and degradation temperature thresholds to be co-sublimated in the same source. It is a particular advantage when one of the materials is a metal and another material is organic.

It is a further advantage of the present invention that it permits linear vaporization rate and vapor composition control by controlling the metering rate of the materials.

It is a further advantage of the present invention that it can rapidly stop and reinitiate vaporization and achieve a steady vaporization rate quickly by controlling the metering rate of the materials, minimizing contamination of the deposition chamber walls and conserving the materials when a substrate is not being coated.

It is a further advantage that the present device achieves substantially higher vaporization rates than in prior art devices with substantially reduced material degradation. Further still, no heater temperature change is required as the source material is consumed.

It is a further advantage of the present invention that it can provide a vapor source in any orientation, which is frequently not possible with previous devices.

### BRIEF DESCRIPTION OF THE DRAWINGS

FIG. 1 is a cross-sectional view of a prior-art vaporization device;
FIG. 2 is a cross-sectional view of one embodiment of a device that is used according to the present invention for mixing and depositing first and second separate vaporized materials onto a substrate surface to form a layer;
FIG. 3 is a cross-sectional view of a device that is used according to the present invention, further including a deposition chamber enclosing a substrate;
FIG. 4 is a cross-sectional view of another embodiment of a portion of the apparatus of FIG. 2 to vaporize material;
FIG. 5 is a three-dimensional view of another embodiment of an apparatus that is used according to the present invention for mixing and depositing first and second separate vaporized materials onto a substrate surface to form a layer;
FIG. 6 is a cross-sectional view of one embodiment of a portion of the apparatus of FIG. 5 for feeding powdered material according to the present invention;
FIG. 7 is a cross-sectional view in further detail of one embodiment of a portion of the above apparatus for feeding and vaporizing powder according to the present invention;
FIG. 8 is a cross-sectional view of another embodiment of a device that is used according to the present invention for vaporizing material including a metal onto a substrate surface to form a layer;
FIG. 9 is a block diagram showing one embodiment of the method of this invention; and
FIG. 10 is a cross-sectional view of an OLED device structure that is prepared in part according to the present invention.

### DETAILED DESCRIPTION OF THE INVENTION

Turning now to FIG. 2, there is shown a cross sectional view of one embodiment of a device that is used according to the present invention. Vaporization apparatus 10 is a device for mixing and depositing first and second separate vaporized materials onto a substrate surface to form a layer. The first material includes a metal. The second material is non-metallic, and in particular includes an organic material or mixture of organic materials. Vaporization apparatus 10 includes a mixing manifold 60, which is disposed so that vaporized materials are deliverable onto the substrate surface. That is, substrate 85 is placed in a position relative to mixing manifold 60 so that vaporized materials exiting mixing manifold 60 through aperture 90 will form a layer on one surface of substrate 85. First heating element 25 and second heating element 40 vaporize first material 15 and second material 20, respectively. The heating elements are disposed so that the vaporized first and second materials are delivered into mixing manifold 60, e.g. in one embodiment the heating elements comprise heated screens at apertures in mixing manifold 60.

First material 15 includes a metal, and desirably a reactive or reducing metal with a work function of less than 4.5 eV. Useful metals for this invention include Al, Li, Cs, Mg, Ca, Ba, or Ag. In some embodiments, as shown in FIG. 2, first material 15 is an elongated member, e.g. a wire, rod, bar. In other embodiments to be described below, first material 15 is powdered or granular. First material 15 is metered at a controlled rate to first heating element 25 by a metering structure 55. When a wire, as shown in FIG. 2, metering structure 55 are e.g. rollers that advance first material 15 at a controlled constant rate and maintain the elongated member in contact with first heating element 25. First material 15 is vaporized by first heating element 25, whereupon the vaporized first material including the metal is delivered into mixing manifold 60.

Second material 20 is a compacted or pre-condensed solid, or a powder. Second material 20 is desirably an organic material. Second material 20 can comprise a single component, or can comprise two or more organic components, each one having a different vaporization temperature. Second material 20 is metered at a controlled rate to a second heating element 40. One example of a metering structure for a second material 20 includes a chamber 65 for receiving a second material 20 and a piston 50, which are controlled through a force-controlled drive mechanism, for raising second material 20 in chamber 65. Second material 20 is vaporized by a second heating element 40, whereupon the vaporized second material is delivered into a mixing manifold 60. The first and second vaporized materials are mixed in a mixing manifold 60 and subsequently deposited onto the surface of a substrate 85 to form a layer, including the metal of a first material 15.

Vaporization apparatus 10 can also include ways for actively cooling at least one of the materials to be below its vaporization temperature in a portion of the apparatus. For example, vaporization apparatus 10 can include, for temperature control, a first region 30 and a second region 35. First region 30
includes a base block 67, which is a heating base block or a cooling base block, or both, and which can include control passages 69 for delivery of heating or cooling fluids. Control passages 69 through base block 67 allow the flow of a temperature control fluid, that is, a fluid adapted to either absorb heat from or deliver heat to the first region 30. The fluid is a gas, a liquid, or a mixed phase. Vaporization apparatus 10 includes a way for pumping fluid through control passages 69. Pumping devices are well-known to those skilled in the art. Second region 35 includes the region bounded by mixing manifold 60 and second heating element 40, which are part of mixing manifold 60. Second material 20 is actively cooled in first region 30 to be kept below its vaporization temperature. Second heating element 40 in second region 35 heats a thin cross-section of second material 20 above its vaporization temperature, whereby the thin cross-section of second material 20 vaporizes. In the case where second material 20 includes two or more organic components, the temperature of second region 35 is chosen to be above the vaporization temperature of each of the components so that each of the second material 20 components simultaneously vaporizes. In this way, there is a steep thermal gradient, which is on the order of 200°C/mm, between first region 30 and second region 35. This gradient protects all but the immediately vaporizing material from the high temperatures, and the bulk of second material 20 is maintained at a temperature at which it has a low rate of degradation. By vaporization temperature, it is meant that the temperature at which the material vaporizes at the rate desired for material deposition on the substrate under the pressure present in mixing manifold 60. The vaporization temperature is determined by various ways. As described by Long et al. in US Publication No. 2005/0186340, the vaporization rate is proportional to the vapor pressure, so for a desired vaporization rate, the required heating temperature corresponding to the desired vaporization rate is determined. Vaporization apparatus 10 can also include one or more shields 70 located adjacent heated mixing manifold 60 for the purpose of reducing the heat radiated to the facing target substrate. Heat shields 70 are thermally connected to base block 67 for the purpose of drawing heat away from the shields. The upper portion of shields 70 is designed to lie below the plane of the apertures for the purpose of minimizing vapor condensation on their relatively cool surfaces.

The current device and method can achieve high vaporization rates, without causing appreciable degradation of organic materials, as has been described by Long et al. in US Publication No. 2005/0186340. However, vaporization apparatus 10 also permits co-vaporization of a metal, wherein the separate vaporized materials (the metal and the organic materials) are mixed in mixing manifold 60 and are deposited together onto the surface of substrate 85 to form a layer. The constant vaporization rate, and constant volume of vaporizing first and second materials 15 and 20 maintained in second region 35 establish and maintain a homogeneous plume with a constant shape. The plume is herein defined as the vapor cloud exiting vaporization apparatus 10. Such layers that include co-evaporated metal and organic material have been found to be useful. For example, Boroson et al., in US Publication No. 2004/0135749, disclose that an electron-transporting layer of tris(8-quinolinolato)aluminum (III) (Alq) with 1.2% co-evaporated lithium metal can provide a lower voltage OLED device with increased lifetime. In this embodiment, first material 15 is lithium metal and second material 20 is Alq. Another use for such layers is as e.g. an n-type doped organic layer in an intermediate connector of a tandem OLED device, as taught by Hatwar et al. in US Application No. 11/217,026.

A pressure develops as vaporization continues and streams of vapor exit mixing manifold 60 through the series of apertures 90. The conductance along the length of the manifold is designed to be roughly two orders of magnitude larger than the sum of the aperture conductances, as described by Grace et al. in US Publication No. 2004/0144321. This conductance ratio promotes effective pressure uniformity within manifold 60 and thereby reducing flow non-uniformities through apertures 90 distributed along the length of the source, despite potential local non-uniformities in vaporization rate.

Because only a small portion of the materials-the portions resident in second region 35-are heated to the rate-dependent vaporization temperature, although the bulk of the materials are kept well below the vaporization temperature, it is possible to interrupt the vaporization by interrupting heating in second heating region 35, e.g. stopping the movements of piston 50 and metering structure 55. This is done when a substrate surface is not being coated to conserve materials and reduce contamination of any associated apparatus, such as the walls of a deposition chamber, which will be described below.

Because second heating element 40 is a fine mesh screen that prevents powder or compacted material from passing freely through it, vaporization apparatus 10 is used in any orientation. For example, vaporization apparatus 10 is oriented 180° from what is shown in FIG. 2 to coat a substrate placed below it.

In practice, vaporization apparatus 10 is used as follows. A quantity of first material is provided into delivery structure 45. A quantity of second material 20, which can comprise one or more components, is provided into chamber 65 of vaporization apparatus 10. In first region 30, second material 20 is actively maintained below the vaporization temperature of each of its organic components. First heating element 25 is heated to a temperature above the vaporization temperature of first material 15. Second heating element 40 is heated to a temperature above the vaporization temperature of second material 20 or each of the components thereof. Both first and second materials 15 and 20, respectively, are metered at controlled rates, whereby they vaporize, mix in mixing manifold 60, and deposit onto a substrate surface to form a layer. When second material 20 includes multiple components, each component simultaneously vaporizes.

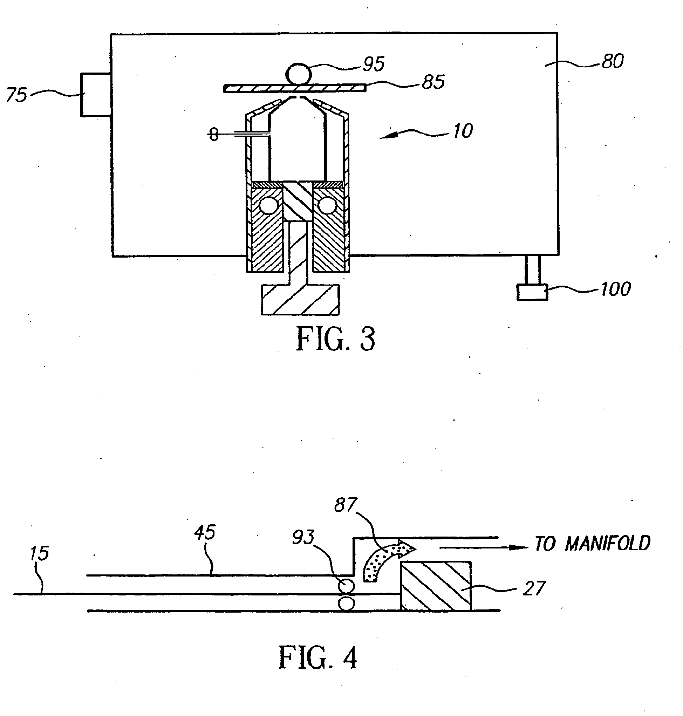

Turning now to FIG. 3, there is shown an embodiment of a device further including a deposition chamber enclosing a substrate for use according to this invention. Deposition chamber 80 is an enclosed apparatus that permits an OLED substrate 85 to be coated with vaporized material transferred from vaporization apparatus 10. Deposition chamber 80 is held under controlled conditions, e.g. a pressure of 1 torr or less provided by vacuum source 100. Deposition chamber 80 includes load lock 75 that is used to load uncoated OLED substrates 85, and unload coated OLED substrates. OLED substrate 85 is moved by translational apparatus 95 to provide even coating of vaporized material over the entire surface of OLED substrate 85. Although vaporization apparatus 10 is shown as partially enclosed by deposition chamber 80, it will be understood that other arrangements are possible, including arrangements wherein vaporization apparatus 10 is entirely enclosed by deposition chamber 80.

In practice, an OLED substrate 85 is placed in deposition chamber 80 via load lock 75 and held by translational apparatus 95 or associated apparatus. Vaporization apparatus 10 is operated as described above, and translational apparatus 95 moves OLED substrate 85 perpendicular to the direction of emission of material vapors from vaporization apparatus 10, thus forming a layer of mixed metallic and non-metallic material on the surface of OLED substrate 85.

In the above vaporization apparatus 10, first heating element 25 is shown as a heated screen. However, the first heating element is not limited to this configuration. For example, turning now to FIG. 4, there is shown a cross-sectional view of another embodiment of a portion of the above apparatus to vaporize first material 15. In this embodiment, first heating element 27 is a heated block. First material 15 is metered at a controlled constant rate as above so that a portion in contact with first heating element 27 vaporizes. Because of the geometry of the apparatus, first material vapor 87 can pass around first heating element 27 to be delivered to the mixing manifold. If necessary, seals 93 can prevent escape of vapors through delivery structure 45.

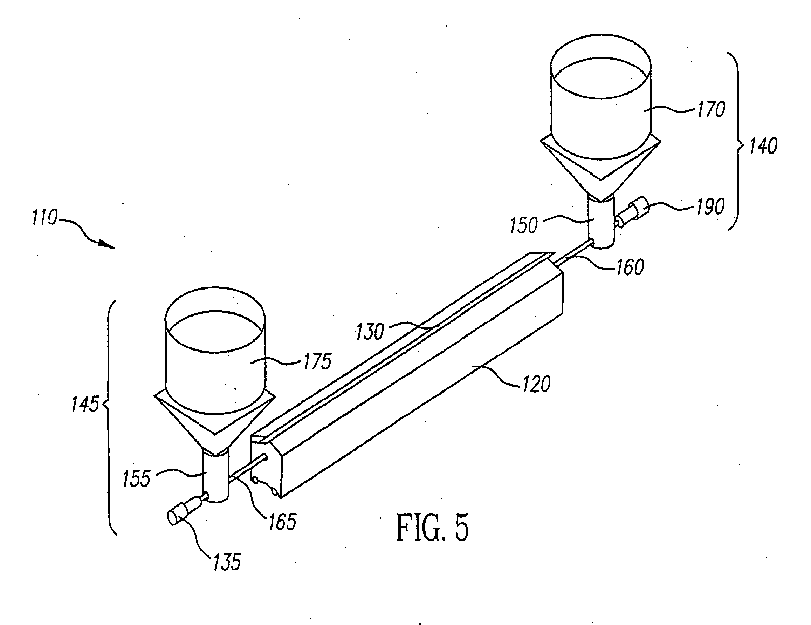

Turning now to FIG. 5, there is shown a three-dimensional view of another embodiment of a device that is used according to the present invention for mixing and depositing first and second separate vaporized materials onto a substrate surface to form a layer. Vaporization apparatus 110 includes manifold 120, attached feeding apparatus 140, and attached feeding apparatus 145. Feeding apparatus 140 includes at least first container 150 and feeding path 160 that is operated by motor 190. Feeding apparatus 145 includes at least second container 155 spaced from first container 150 and feeding path 165 that is operated by motor 135. First container 150 is provided with a quantity of a first material in a powdered or granular form. Second container 155 is provided with a quantity of a second material in a powdered form. The compositions of the first and second materials are as described above. Feeding apparatus 140 can also include third container 170, and feeding apparatus 145 can also include fourth container 175. Third container 170 is associated with first container 150 and the first material. Fourth container 175 is associated with second container 155 and the second material. Third container 170 and fourth container 175 can receive first and second materials, respectively, and transfer them to first container 150 and second container 155, respectively, as will become apparent. Manifold 120 includes one or more apertures 130 through which vaporized organic material can exit to a substrate surface. Manifold 120 is shown in an orientation whereby it can form a layer on a horizontally-oriented substrate, but it is not limited to this orientation. Manifold 120 is oriented vertically and can form a layer on a vertical substrate. Manifold 120 has been described in detail by Long et al. in US Patent Application No. 10/784,585. Feeding apparatus 140 and feeding apparatus 145 are shown attached to opposite sides of manifold 120, but they can also be attached to the same side of manifold 120, or to the bottom of manifold 120 if the manifold is in a vertical orientation. The nature of the attachment of feeding apparatus 140 to manifold 120 will become clear.

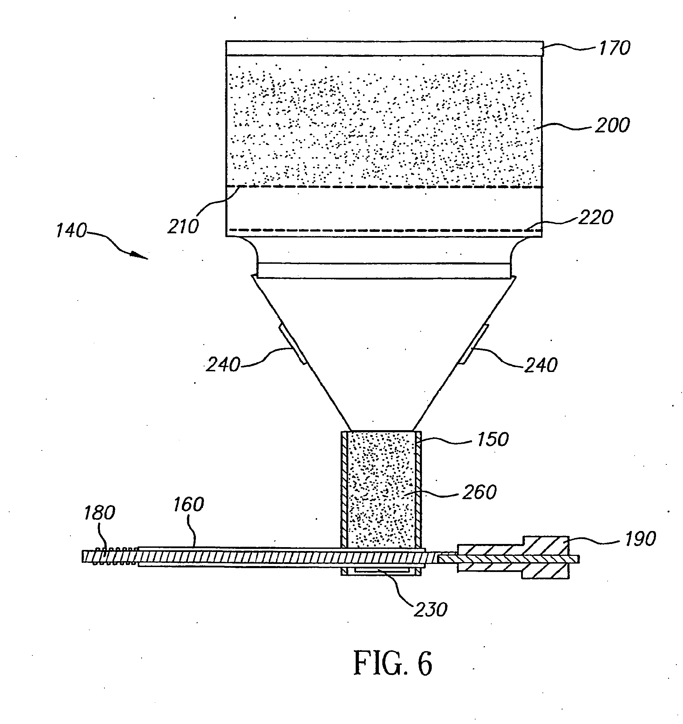

Turning now to FIG. 6, there is shown a cross-sectional view of one embodiment of a portion of the above vaporization apparatus for feeding powdered or a granular material according to the present invention whereby material is fluidized and transferred to an auger structure. First container 150 holds first material 260, which is a metal in the form of granules or a finely divided powder and is desirably of a uniform size, and which feeds into auger structure 180 in feeding path 160. Auger structure 180 passes through the interior of first container 150 and feeds into the manifold described above (not shown for clarity). At least a portion of auger structure 180 is rotated by motor 190 so as to transfer the first material at a controlled volumetric rate or pressure along feeding path 160 to a vaporization zone where the first material is vaporized, subsequently mixed with second vaporized material, and delivered to and deposited on a substrate to form a layer. Feeding path 160, and therefore first material in feeding path 160, is maintained at a temperature below the desired vaporization temperature of the material. To facilitate the movement of first material 260 to auger structure 180, first material 260 are fluidized by agitating first material 260 by using an agitating device, e.g. piezoelectric structure 230 or an electromechanical vibrator. Such fluidized material is more readily transferred to auger structure 180 by gravity feed.

The addition of optional third container 170 to hold additional first material provides several additional advantages. A large quantity of first material 200 is charged in the apparatus, allowing continuous operation of the device for extended periods of time as described by Long et al. in US Application No. 10/945,941, by Long et al. and US Patent Application No. 10/945,940. Also, third container 170 is arranged to be refillable without affecting the operation of first container 150, allowing the device to be continuously operated for even longer periods of time. First material 200 is maintained in third container 170 by e.g. screens 210 and 220, whose mesh size is chosen to prevent the free flow of powdered material, but to allow controlled flow. Screens 210 and 220 can also be the mechanism for providing measured quantities of first material to move from third container 170 to first container 150 via contact by agitating devices (not shown) that is actuated to cause a quantity of powder to pass through the screen. Such devices include those to vibrate the screen, or a movable arm immediately above or below the screen to allow selective agitation of screens 210 and 220. agitating devices such as piezoelectric structures 240 prevent the buildup of organic material in the feed path to first container 150. Feeding apparatus 145 of FIG. 5 operates in an analogous manner with second container 155, fourth container 175, feeding path 165, and motor 135 for metering the amount of second material.

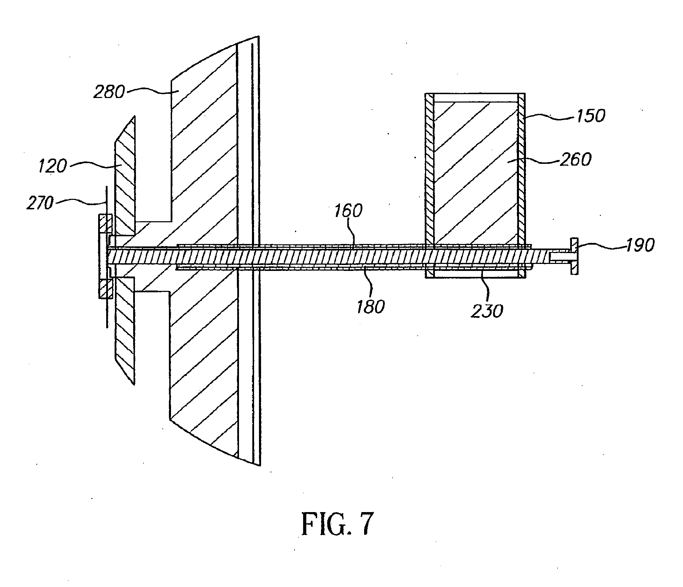

Turning now to FIG. 7, there is shown in further detail a cross-sectional view of one embodiment of a portion of the above apparatus for feeding and vaporizing powder according to the present invention. Auger structure 180 transfers first organic material powder along feeding path 160 into manifold 120 and heating element 270. Heating element 270 is e.g. a heated screen and has been previously described in detail by Long et al. Manifold 120 includes a vaporization zone which is defined as the region of feeding path 160 immediately adjacent to heating element 270. A thin cross-section of first material powder is heated to the desired rate-dependent vaporization temperature, which is the temperature of heating element 270, by virtue of contact and thermal conduction, whereby the thin cross-section of first material powder vaporizes. Similarly, feeding apparatus 145 of FIG. 5 transfers the second material into manifold 120 at a second heating element, where the second material vaporizes in manifold 120. The first and second vaporized materials are mixed in manifold 120, and subsequently delivered to a substrate surface and deposited to form a layer. The structure of auger structure 180 and the rotation rate control the rate at which first material is fed to heating element 270. This linearly controls the rate of vaporization and therefore the rate at which the material leaves the manifold in the vapor state. Thus the feed rate of the first material to the auger structure and to the vaporization zone controls the deposition rate of the vaporized first material onto the desired surface. With two such structures, as in Fig.5, the relative feed rates of the first and second materials to the respective auger structures and the respective vaporization zones controls the relative partial pressures of the first and second materials in the manifold, and hence their relative deposition rates and concentrations in the deposited layer.

Additionally, base 280 is included. Base 280 is a heat-dissipating structure to prevent much of the heat from heating element 270 from traversing the length of feeding path 160, and thus can actively cool the material to be below its vaporization temperature because heating element 270 heats the material above its vaporization temperature. Ways of heat dissipation for base 280 have been described by Long et al. in U.S. Patent Application 10/784,585). A steep thermal gradient thereby created protects all but the immediately vaporizing material from the high temperatures. This is particularly important when the first material is a low-melting metal (e.g. lithium), or the second material is an organic material. The vaporized material rapidly passes through heating element 270 and can enter into the heated manifold 120.

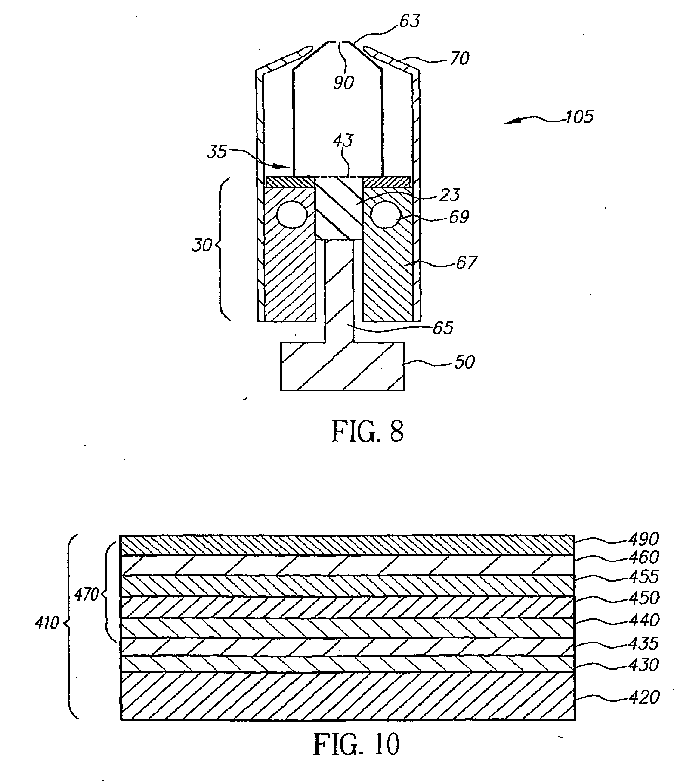

Turning now to FIG. 8, there is shown a cross-sectional view of another embodiment of a device that is used according to the present invention. Vaporization apparatus 105 is a device for vaporizing material including a metal onto a substrate surface to form a layer. It is similar to vaporization apparatus 10 described above, but includes only a single heating element 43, which is disposed so that vaporized material is deliverable into manifold 63. Manifold 63 is disposed so that vaporized materials are deliverable onto a substrate surface to form a layer. Material 23 includes both a metal and a non-metallic material. Material 23 can comprise e.g. powdered first material and powdered second material, as described above, that have previously been mixed in the desired proportion. Material 23, including the metal, is metered, e.g. by piston 50, at a controlled rate to heating element 43. Heating element 43 has a temperature sufficient to vaporize the material including the metal, whereupon the vaporized material is delivered to manifold 63 to be subsequently deposited via apertures 90 on the surface of a substrate. The deposited vapors form a layer including the metal on the substrate surface.

Material 23 is actively cooled in first region 30 to be kept below its vaporization temperature in a portion of the apparatus. Heating element 43 in second region 35 heats a thin cross-section of material 23 above its vaporization temperature, whereby the thin cross-section of material 23 vaporizes. The temperature of second region 35 is chosen to be above the vaporization temperature of each of the components, including the metal, so that each of the material 23 components simultaneously vaporizes. In this way, there is a steep thermal gradient, which is on the order of 500°C/mm as disclosed by Long et al. in US Patent Application 10/945,940 and US Patent application 11/134,654, between first region 30 and second region 35. This gradient protects all but the immediately vaporizing material from the high temperatures, and the bulk of material 23 is maintained at a temperature at which it has a low rate of degradation.

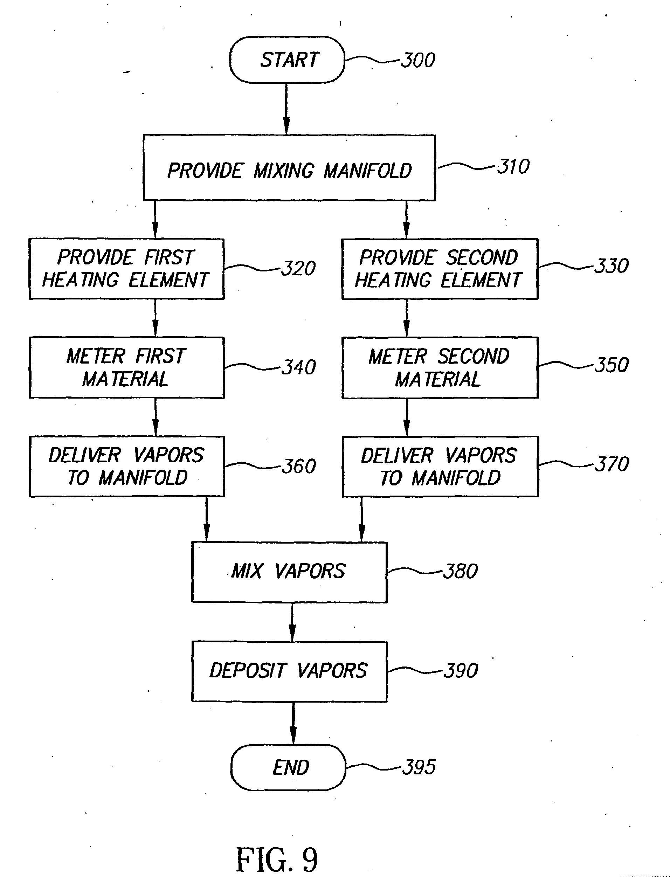

Turning now to FIG. 9, and referring also to FIG. 2, there is shown a block diagram showing one embodiment of the method of this invention for mixing and depositing first and second separate vaporized materials onto a substrate surface to form a layer. The first material includes a metal and the second material is non-metallic. At the start (Step 300), a mixing manifold 60 is provided disposed so that vaporized materials in the manifold are deliverable onto a substrate surface (Step 310). First heating element 25 for vaporizing first material 15 and second heating element 40 for vaporizing second material 20 are provided (Steps 320 and 330). The heating elements are disposed so that the vaporized first and second materials 15 and 20 are deliverable into mixing manifold 60. First material 15 is metered at a controlled rate to first heating element 25 (Step 340) and the vaporized material, including the metal, is delivered to mixing manifold 60 (Step 360). Simultaneously, second material 20 is metered at a controlled rate to second heating element 40 (Step 350) and the vaporized material is delivered to mixing manifold 60 (Step 370), where the vaporized first and second materials mix (Step 380). The vaporized materials are subsequently deposited onto the surface of OLED substrate 85 (Step 390) to form a layer including the metal, after which the process ends (Step 395).

Variations on this basic method are possible. In one example, the method can include a step just before step 350 to actively cool at least one of the materials, e.g. second material 20 in first region 30 to be below its vaporization temperature. In another example, Steps 310, 320, 340, 360, and 390 is used with vaporization apparatus 105 of FIG. 8 in a method to vaporize material including a metal onto a substrate surface to form a layer.

Turning now to FIG. 10, there is shown a cross-sectional view of a pixel of a light-emitting OLED device 410 that is prepared in part according to the present invention. The OLED device 410 includes at a minimum a substrate 420, a cathode 490, an anode 430 spaced from cathode 490, an electron-transporting layer 455, and a light-emitting layer 450. The OLED device can also include a hole-injecting layer 435, a hole-transporting layer 440, and an electron-injecting layer 460. Hole-injecting layer 435, hole-transporting layer 440, light-emitting layer 450, electron-transporting layer 455, and electron-injecting layer 460 comprise a series of organic layers 470 disposed between anode 430 and cathode 490. Electron-transporting layer 455 is an example of the organic material layers most desirably deposited by the method of this invention. These components will be described in more detail.

Substrate 420 is an organic solid, an inorganic solid, or includes organic and inorganic solids. Substrate 420 is rigid or flexible and is processed as separate individual pieces, such as sheets or wafers, or as a continuous roll. Typical substrate materials include glass, plastic, metal, ceramic, semiconductor, metal oxide, semiconductor oxide, semiconductor nitride, or combinations thereof. Substrate 420 is a homogeneous mixture of materials, a composite of materials, or multiple layers of materials. Substrate 420 is an OLED substrate, that is a substrate commonly used for preparing OLED devices, e.g. active-matrix low-temperature polysilicon or amorphous-silicon TFT substrate. The substrate 420 can either be light transmissive or opaque, depending on the intended direction of light emission. The light transmissive property is desirable for viewing the EL emission through the substrate. Transparent glass or plastic is commonly employed in such cases. For applications where the EL emission is viewed through the top electrode, the transmissive characteristic of the bottom support is immaterial, and therefore is light transmissive, light absorbing or light reflective. Substrates for use in this case include, but are not limited to, glass, plastic, semiconductor materials, ceramics, and circuit board materials, or any others commonly used in the formation of OLED devices, which is either passive-matrix devices or active-matrix devices.

An electrode is formed over substrate 420 and is most commonly configured as an anode 430. When EL emission is viewed through the substrate 420, anode 430 should be transparent or substantially transparent to the emission of interest. Common transparent anode materials useful in this invention are indium-tin oxide and tin oxide, but other metal oxides can work including, but not limited to, aluminum- or indium-doped zinc oxide, magnesium-indium oxide, and nickel-tungsten oxide. In addition to these oxides, metal nitrides such as gallium nitride, metal selenides such as zinc selenide, and metal sulfides such as zinc sulfide, is used as an anode material. For applications where EL emission is viewed through the top electrode, the transmissive characteristics of the anode material are immaterial and any conductive material is used, transparent, opaque or reflective. Example conductors for this application include, but are not limited to, gold, iridium, molybdenum, palladium, and platinum. The preferred anode materials, transmissive or otherwise, have a work function of 4.1 eV or greater. Desired anode materials are deposited by any suitable way such as evaporation, sputtering, chemical vapor deposition, or electrochemical processes. Anode materials are patterned using well known photolithographic processes.

Because not always necessary, it is often useful that a hole-injecting layer 435 be formed over anode 430 in an organic light-emitting display. The hole-injecting material can serve to improve the film formation property of subsequent organic layers and to facilitate injection of holes into the hole-transporting layer. Suitable materials for use in hole-injecting layer 435 include, but are not limited to, porphyrinic compounds as described in U.S. Patent 4,720,432, plasma-deposited fluorocarbon polymers as described in U.S. Patent 6,208,075, and inorganic oxides including vanadium oxide (VOx), molybdenum oxide (MoOx), nickel oxide (NiOx). Alternative hole-injecting materials reportedly useful in organic EL devices are described in EP 0 891 121 A1 and EP 1 029 909 A1.

Because not always necessary, it is often useful that a hole-transporting layer 440 be formed and disposed over anode 430. Desired hole-transporting materials are deposited by any suitable way such as evaporation, sputtering, chemical vapor deposition, electrochemical structure, thermal transfer, or laser thermal transfer from a donor material. Hole-transporting materials useful in hole-transporting layer 440 are well known to include compounds such as an aromatic tertiary amine, where the latter is understood to be a compound containing at least one trivalent nitrogen atom that is bonded only to carbon atoms, at least one of which is a member of an aromatic ring. In one form the aromatic tertiary amine is an arylamine, such as a monoarylamine, diarylamine, triarylamine, or a polymeric arylamine. Exemplary monomeric triarylamines are illustrated by Klupfel et al. in U.S. Patent 3,180,730. Other suitable triarylamines substituted with one or more vinyl radicals and comprising at least one active hydrogen-containing group are disclosed by Brantley et al. in U.S. Patents 3,567,450 and 3,658,520.

A more preferred class of aromatic tertiary amines are those which include at least two aromatic tertiary amine moieties as described in U.S. Patents 4,720,432 and 5,061,569. Such compounds include those represented by structural Formula A. 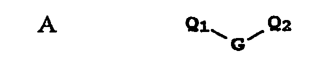 wherein:
Q₁ and Q₂ are independently selected aromatic tertiary amine moieties; and
G is a linking group such as an arylene, cycloalkylene, or alkylene group of a carbon to carbon bond.

In one embodiment, at least one of Q1 or Q2 contains a polycyclic fused ring structure, e.g., a naphthalene. When G is an aryl group, it is conveniently a phenylene, biphenylene, or naphthalene moiety.

A useful class of triarylamines satisfying structural Formula A and containing two triarylamine moieties is represented by structural Formula B. 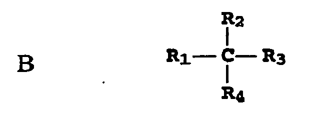 where:
R₁ and R₂ each independently represent a hydrogen atom, an aryl group, or an alkyl group or R₁ and R₂ together represent the atoms completing a cycloalkyl group; and
R₃ and R₄ each independently represent an aryl group, which is in turn substituted with a diaryl substituted amino group, as indicated by structural Formula C. 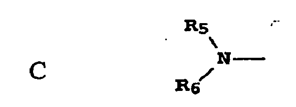 wherein R₅ and R₆ are independently selected aryl groups. In one embodiment, at least one of R₅ or R₆ contains a polycyclic fused ring structure, e.g., a naphthalene.

Another class of aromatic tertiary amines is the tetraaryldiamines. Desirable tetraaryldiamines include two diarylamino groups, such as indicated by Formula C, and linked through an arylene group. Useful tetraaryldiamines include those represented by Formula D. 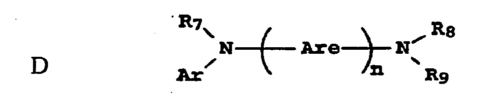 wherein:
each Are is an independently selected arylene group, such as a phenylene or anthracene moiety;
n is an integer of from 1 to 4; and
Ar, R₇, Rg, and R₉ are independently selected aryl groups.

In a typical embodiment, at least one of Ar, R₇, R₈, and R₉ is a polycyclic fused ring structure, e.g., a naphthalene.

The various alkyl, alkylene, aryl, and arylene moieties of the foregoing structural Formulae A, B, C, D, can each in turn be substituted. Typical substituents include alkyl groups, alkoxy groups, aryl groups, aryloxy groups, and halogens such as fluoride, chloride, and bromide. The various alkyl and alkylene moieties typically contain from 1 to about 6 carbon atoms. The cycloalkyl moieties can contain from 3 to about 10 carbon atoms, but typically contain five, six, or seven carbon atoms--e.g., cyclopentyl, cyclohexyl, and cycloheptyl ring structures. The aryl and arylene moieties are typically phenyl and phenylene moieties.

The hole-transporting layer in an OLED device is formed of a single or a mixture of aromatic tertiary amine compounds. Specifically, one can employ a triarylamine, such as a triarylamine satisfying the Formula B, in combination with a tetraaryldiamine, such as indicated by Formula D. When a triarylamine is employed in combination with a tetraaryldiamine, the latter is positioned as a layer interposed between the triarylamine and the electron-injecting and transporting layer.

Another class of useful hole-transporting materials includes polycyclic aromatic compounds as described in EP 1 009 041. In addition, polymeric hole-transporting materials is used such as poly(N-vinylcarbazole) (PVK), polythiophenes, polypyrrole, polyaniline, and copolymers such as poly(3,4-ethylenedioxythiophene)/poly(4-styrenesulfonate) also called PEDOT/PSS.

Light-emitting layer 450 produces light in response to hole-electron recombination. Light-emitting layer 450 is commonly disposed over hole-transporting layer 440. Desired organic light-emitting materials is deposited by any suitable structure such as evaporation, sputtering, chemical vapor deposition, electrochemical structure, or radiation thermal transfer from a donor material. Useful organic light-emitting materials are well known. As more fully described in U.S. Patents 4,769,292 and 5,935,721, the light-emitting layers of the organic EL element comprise a luminescent or fluorescent material where electroluminescence is produced as a result of electron-hole pair recombination in this region. The light-emitting layers is comprised of a single material, but more commonly include a host material doped with a guest compound or dopant where light emission comes primarily from the dopant. The dopant is selected to produce color light having a particular spectrum. The host materials in the light-emitting layers are an electron-transporting material, as defined below, a hole-transporting material, as defined above, or another material that supports hole-electron recombination. The dopant is typically chosen from highly fluorescent dyes, but phosphorescent compounds, e.g., transition metal complexes as described in WO 98/55561, WO 00/18851, WO 00/57676, and WO 00/70655 are also useful. Dopants are typically coated as 0.01 to 10 % by weight into the host material. The device and method described herein is used to coat multicomponent guest/host layers without the need for multiple vaporization sources.

Host and emitting molecules known to be of use include, but are not limited to, those disclosed in U.S. Patents 4,768,292; 5,141,671; 5,150,006; 5,151,629; 5,294,870; 5,405,709; 5,484,922; 5,593,788; 5,645,948; 5,683,823; 5,755,999; 5,928,802; 5,935,720; 5,935,721; and 6,020,078.

Metal complexes of 8-hydroxyquinoline and similar derivatives (Formula E) constitute one class of useful host materials capable of supporting electroluminescence, and are particularly suitable for light emission of wavelengths longer than 500 nm, e.g., green, yellow, orange, and red. 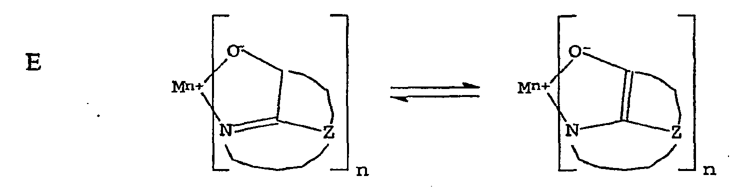 wherein:
M represents a metal;
n is an integer of from 1 to 3; and
Z independently in each occurrence represents the atoms completing a nucleus having at least two fused aromatic rings.

From the foregoing it is apparent that the metal is a monovalent, divalent, or trivalent metal. The metal can, for example, be an alkali metal, such as lithium, sodium, or potassium; an alkaline earth metal, such as magnesium or calcium; or an earth metal, such as boron or aluminum. Generally any monovalent, divalent, or trivalent metal known to be a useful chelating metal is employed.

Z completes a heterocyclic nucleus containing at least two fused aromatic rings, at least one ofwhich is an azole or azine ring. Additional rings, including both aliphatic and aromatic rings, are fused with the two required rings, if required. To avoid adding molecular bulk without improving on function the number of ring atoms are typically maintained at 18 or less.

The host material in light-emitting layer 450 is an anthracene derivative having hydrocarbon or substituted hydrocarbon substituents at the 9 and 10 positions. For example, derivatives of 9,10-di-(2-naphthyl)anthracene constitute one class of useful host materials capable of supporting electroluminescence, and are particularly suitable for light emission of wavelengths longer than 400 nm, e.g., blue, green, yellow, orange or red.

Benzazole derivatives constitute another class of useful host materials capable of supporting electroluminescence, and are particularly suitable for light emission of wavelengths longer than 400 nm, e.g., blue, green, yellow, orange or red. An example of a useful benzazole is 2, 2', 2"-(1,3,5-phenylene)tris[1-phenyl-1H-benzimidazole].

Desirable fluorescent dopants include perylene or derivatives of perylene, derivatives of anthracene, tetracene, xanthene, rubrene, coumarin, rhodamine, quinacridone, dicyanomethylenepyran compounds, thiopyran compounds, polymethine compounds, pyrilium and thiapyrilium compounds, derivatives of distryrylbenzene or distyrylbiphenyl, bis(azinyl)methane boron complex compounds, and carbostyryl compounds.

Other organic emissive materials is polymeric substances, e.g. polyphenylenevinylene derivatives, dialkoxy-polyphenylenevinylenes, poly-para-phenylene derivatives, and polyfluorene derivatives, as taught by Wolk et al. in commonly assigned U.S. Patent 6,194,119 B1 and references cited therein.

It is useful that OLED device 410 includes an electron-transporting layer 455 disposed over light-emitting layer 450. Desired electron-transporting materials is deposited by any suitable structure such as evaporation, sputtering, chemical vapor deposition, electrochemical structure, thermal transfer, or laser thermal transfer from a donor material, and is deposited by the device and method described herein. In particular, it is envisioned that an electron-transporting layer doped with a metal is formed by the method of this invention. Preferred electron-transporting materials for use in electron-transporting layer 455 are metal chelated oxinoid compounds, including chelates of oxine itself (also commonly referred to as 8-quinolinol or 8-hydroxyquinoline). Such compounds help to inject and transport electrons and exhibit both high levels of performance and are readily fabricated in the form of thin films. Exemplary of contemplated oxinoid compounds are those satisfying structural Formula E, previously described.

Other electron-transporting materials include various butadiene derivatives as disclosed in U.S. Patent 4,356,429 and various heterocyclic optical brighteners as described in U.S. Patent 4,539,507. Benzazoles satisfying structural Formula G are also useful electron-transporting materials.

Other electron-transporting materials are polymeric substances, e.g. polyphenylenevinylene derivatives, poly-para-phenylene derivatives, polyfluorene derivatives, polythiophenes, polyacetylenes, and other conductive polymeric organic materials such as those listed in Handbook of Conductive Molecules and Polymers, Vols. 1-4, H.S. Nalwa, ed., John Wiley and Sons, Chichester (1997).

An electron-injecting layer 460 can also be present between the cathode and the electron-transporting layer. Examples of electron-injecting materials include alkaline or alkaline earth metals, alkali halide salts, such as LiF mentioned above, or alkaline or alkaline earth metal doped organic layers.

Cathode 490 is formed over the electron-transporting layer 455. When light emission is through the anode 430, the cathode material is comprised of nearly any conductive material. Desirable materials have effective film-forming properties to ensure effective contact with the underlying organic layer, promote electron injection at low voltage, and have effective stability. Useful cathode materials often contain a low work function metal (< 3.0 eV) or metal alloy. One preferred cathode material is comprised of a Mg:Ag alloy wherein the percentage of silver is in the range of 1 to 20 %, as described in U.S. Patent 4,885,221. Another suitable class of cathode materials includes bilayers comprised of a thin layer of a low work function metal or metal salt capped with a thicker layer of conductive metal. One such cathode is comprised of a thin layer of LiF followed by a thicker layer of A1 as described in U.S. Patent 5,677,572. Other useful cathode materials include, but are not limited to, those disclosed in U.S. Patents 5,059,8.61; 5,059,862; and 6,140,763.

When light emission is viewed through cathode 490, it should be transparent or nearly transparent. For such applications, metals should be thin or one should use transparent conductive oxides, or includes these materials. Optically transparent cathodes have been described in more detail in U.S. Patent 5,776,623. Cathode materials are deposited by evaporation, sputtering, or chemical vapor deposition. When needed, patterning is achieved through many well known methods including, but not limited to, through-mask deposition, integral shadow masking as described in U.S. Patent 5,276,380 and EP 0 732 868, laser ablation, and selective chemical vapor deposition.

### PARTS LIST

- 4: vaporization device
- 5: substrate
- 6: source
- 7: source
- 8: source
- 9: vapor plume
- 10: vaporization apparatus
- 15: first material
- 20: second material
- 23: material
- 25: first heating element
- 27: first heating element
- 30: first region
- 35: second region
- 40: second heating element
- 43: heating element
- 45: delivery structure
- 50: piston
- 55: metering structure
- 60: mixing manifold
- 63: manifold
- 65: chamber
- 67: base block
- 69: control passage
- 70: shield
- 75: load lock
- 80: deposition chamber
- 85: OLED substrate
- 87: first material vapor
- 90: aperture
- 93: seal
- 95: translational apparatus
- 100: vacuum source
- 105: vaporization apparatus
- 110: vaporization apparatus
- 120: manifold
- 130: aperture
- 135: motor
- 140: feeding apparatus
- 145: feeding apparatus
- 150: first container
- 155: second container
- 160: feeding path
- 165: feeding path
- 170: third container
- 175: fourth container
- 180: auger structure
- 190: motor
- 200: first material
- 210: screen
- 220: screen
- 230: piezoelectric structure
- 240: piezoelectric structure
- 260: first material
- 270: heating element
- 280: base
- 300: step
- 310: step
- 320: step
- 330: step
- 340: step
- 350: step
- 360: step
- 370: step
- 380: step
- 390: step
- 395: step
- 410: OLED device
- 420: substrate
- 430: anode
- 435: hole-injecting layer
- 440: hole-transporting layer
- 450: light-emitting layer
- 455: electron-transporting layer
- 460: electron-injecting layer
- 470: organic layers
- 490: cathode

## Claims

1. A method for mixing and depositing first and second separate vaporized materials onto a substrate surface (85) to form a layer wherein the first material includes a metal and the second material is non-metallic, comprising:
a) providing a mixing manifold (60) disposed so that vaporized materials are deliverable onto the substrate surface (85);
b) providing first and second heating elements (25, 40) for separately vaporizing the first and second materials, the heating elements being disposed so that the vaporized materials are deliverable into the mixing manifold (60); and
c) metering at a controlled rate the first and second materials to the first and second heating elements respectively, so that vaporized materials, including the metal, are delivered to the mixing manifold (60) where they are mixed and subsequently deposited onto the substrate surface to form the layer including the metal.

2. The method of claim 1 further including actively cooling at least one of the materials in a first region to be below its vaporization temperature and the corresponding heating element heating the material in a second region above its vaporization temperature so that there is a steep thermal gradient between the first and second regions.

3. The method of claim 1 wherein the first material is in the form of an elongated member and the metering step includes maintaining the elongated member in contact with the first heating element.

4. The method of claim 1 wherein the material includes reactive or reducing metal with a work function of less than 4.5 eV.

5. The method of claim 4 wherein the first material includes Al, Li, Cs, Mg, Ca, Ba, or Ag.

6. The method of claim 1 wherein the second material includes an organic material having one or more components.

## Patentansprüche

1. Verfahren zum Mischen und Abscheiden von ersten und zweiten getrennt verdampften Materialien auf eine Substratoberfläche (85) zur Bildung einer Schicht, wobei das erste Material ein Metall einschließt und das zweite Material nicht-metallisch ist, umfassend:
a) Vorsehen eines Mischverteilerstücks (60), das so angeordnet ist, dass verdampfte Materialien auf eine Substratoberfläche (85) zugeführt werden können;
b) Vorsehen von ersten und zweiten Heizelementen (25,40) zum getrennten Verdampfen der ersten und zweiten Materialien, wobei die Heizelemente so angeordnet sind, dass die verdampften Materialien dem Mischverteilerstück (60) zugeführt werden können; und
c) Dosieren mit einer kontrollierten Rate der ersten und zweiten Materialien in das erste bzw. zweite Heizelement, so dass verdampfte Materialien, einschließlich des Metalls, dem Mischverteilerstück (60) zugeführt werden, wo sie vermischt werden und anschließend auf die Substratoberfläche abgeschieden werden zur Bildung der das Metall einschließenden Schicht.

2. Verfahren gemäß Anspruch 1, weiterhin einschließend das aktive Abkühlen mindestens eines der Materialien in einer ersten Region auf unterhalb von dessen Verdampfungstemperatur und des entsprechenden Heizelements, welches das Material in einer zweiten Region erwärmt, auf oberhalb von dessen Verdampfungstemperatur, so dass es zu einem steilen Wärmegefälle zwischen der ersten und zweiten Region kommt.

3. Verfahren gemäß Anspruch 1, wobei das erste Material die Form eines länglichen Teils aufweist und der Dosierschritt das Inkontakthalten des länglichen Teils mit dem ersten Heizelement einschließt.

4. Verfahren gemäß Anspruch 1, wobei das Material reaktives oder reduzierendes Metall mit einer Austrittsarbeit von weniger als 4,5 eV einschließt.

5. Verfahren gemäß Anspruch 4, wobei das erste Material Al, Li, Cs, Mg, Ca, Ba oder Ag einschließt.

6. Verfahren gemäß Anspruch 1, wobei das zweite Material ein organisches Material mit einer oder mehreren Komponenten einschließt.

## Revendications

1. Procédé de mélange et de dépôt d'une première et d'une deuxième matières vaporisées séparées sur une surface (85) de substrat pour former une couche dans laquelle la première matière inclut un métal et la deuxième matière est non métallique, comprenant :
a) la prévision d'un collecteur de mélange (60) disposé de telle manière que des matières vaporisées peuvent être délivrées sur la surface (85) de substrat ;
b) la prévision d'un premier et d'un deuxième éléments chauffants (25, 40) pour vaporiser séparément la première et la deuxième matières, les éléments chauffants étant disposés de telle manière que les matières vaporisées peuvent être délivrées dans le collecteur de mélange (60) ; et
c) la mesure à un débit contrôlé de la première et la deuxième matières dans le premier et le deuxième éléments chauffants respectivement, de telle manière que les matières vaporisées, incluant le métal, sont délivrées dans le collecteur de mélange (60) où elles sont mélangées et ensuite déposées sur la surface de substrat pour former la couche incluant le métal.

2. Procédé selon la revendication 1, incluant en outre le refroidissement actif d'au moins une des matières dans une première région pour qu'elle soit en-dessous de sa température de vaporisation et l'élément chauffant correspondant chauffant la matière dans une deuxième région au-dessus de sa température de vaporisation de manière à ce qu'il y ait un gradient thermique abrupt entre la première et la deuxième régions.

3. Procédé selon la revendication 1, dans lequel la première matière est sous la forme d'un élément allongé et l'étape de mesure inclut le maintien de l'élément allongé en contact avec le premier élément chauffant.

4. Procédé selon la revendication 1, dans lequel la matière inclut un métal réactif ou réducteur avec un travail d'extraction de moins de 4,5 eV.

5. Procédé selon la revendication 4, dans lequel la première matière inclut Al, Li, Cs, Mg, Ca, Ba ou Ag.

6. Procédé selon la revendication 1, dans lequel la deuxième matière inclut une matière organique ayant un ou plusieurs composant(s).
